Europäisches Patentamt

European Patent Office

Office européen des brevets

(19)

(11) Numéro de publication: **0 023 165 B1**

(12) **FASCICULE DE BREVET EUROPEEN**

(45) Date de publication du fascicule du brevet: **18.05.83**

(51) Int. Cl.³: **H 01 L 23/48, H 01 L 23/36**

(21) Numéro de dépôt: **80400971.0**

(22) Date de dépôt: **27.06.80**

(54) **Plate-forme support de grille de connexion, notamment pour boîtier de circuits intégrés, et boîtier comportant une telle plate-forme.**

(30) Priorité: **17.07.79 FR 7918465**

(43) Date de publication de la demande:
**28.01.81 Bulletin 81/4**

(45) Mention de la délivrance du brevet:
**18.05.83 Bulletin 83/20**

(84) Etats contractants désignés:
**DE GB IT**

(56) Documents cités:
**FR - A - 2 025 720**
**FR - A - 2 245 084**
**FR - A - 2 326 039**
**FR - A - 2 337 944**

(73) Titulaire: **THOMSON-CSF**
**173, Boulevard Haussmann**
**F-75379 Paris Cedex 08 (FR)**

(72) Inventeur: **Dardelet, Yves**
**"THOMSON-CSF" SCPI 173, Bld Haussmann**
**F-75360 Paris Cedex 08 (FR)**

(74) Mandataire: **de Beaumont, Michel et al,**
**THOMSON-CSF SCPI 173, Bld Haussmann**
**F-75379 Paris Cedex 08 (FR)**

Courier Press, Leamington Spa, England.

Plate-forme support de grille de connexion, notamment pour boitier de circuits integres, et
boîtier comportant une telle plate-forme

L'invention est relative à une plate-forme support de grille de connexion, notamment pour boîtier de circuits intégrés, et au boîtier comportant une telle plate-forme.

La qualité des connexions des pastilles de circuits intégrés reste actuellement un des problèmes majeurs en ce qui concerne la fiabilité de ces circuits. Afin de réduire au maximum les contraintes mécaniques appliquées à ces connexions, ces circuits intégrés sont actuellement présentés sous forme d'un boîtier comportant au moins une plate-forme support conductrice sur laquelle est soudée une pastille de circuits intégrés et des broches ou brins conducteurs disposés selon une grille de connexion au voisinage de la pastille. Les connexions sont effectuées par des fils conducteurs entre les extrémités des brins et les points de contact de la pastille, l'ensemble étant noyé dans un matériau thermodurcissable isolant, les divers brins formant la grille de connexion étant ensuite électriquement isolés.

De telles plates-formes support ont été décrites notamment dans le brevet US 4 012 765. Elles sont présentées sous forme d'une bande formant un double alignement de plates-formes support. Chaque plate-forme comporte un tenon replié dans une direction perpendiculaire au plan de la plate-forme et destiné à recevoir une grille de connexion par assemblage. Le tenon et l'assemblage permettent d'assurer d'une part le contact électrique entre la plate-forme support et un des brins de la grille de connexion et, d'autre part, un espacement des plans de la plate-forme support et de la grille de connexion réalisant, après séparation des brins et enrobage dans le matérieu thermodurcissable, l'isolation de ces derniers par rapport à la plate-forme support.

De tels dispositifs présentent cependant l'inconvénient de l'existence d'une zone d'affaiblissement du tenon au niveau de sa zone de pliage impropre à la réalisation d'une soudure du fil conducteur correspondant au brin de la grille en contact avec le tenon, nécessitant de ce fait l'utilisation d'un fil conducteur de plus grande longueur que celle des autres brins conducteurs afin d'effectuer une soudure convenable de ce conducteur au delà de la zone de pliage du tenon.

De plus, l'assemblage par tenon n'autorise qu'un positionnement peu précis de la grille de connexion notamment en ce qui concerne l'espacemet entre plan de la grille de connexion et plan de la plate-forme support, le brin en contact avec le tenon ne pouvant pas être supporté entre l'extrémité du brin où est effectuée la soudure du conducteur et la zone d'assemblage par tenon.

Le brevet français FR—A—2 025 720 décrit un mode d'assemblage par une patte; verticale dont la partie supérieure comporte une gorge toutefois, ce brevet ne concerne pas un montage de grille de connexion mais de conducteurs sous forme de fils ronds maintenus á distance prédéterminée l'un de l'autre par un support rigide isolant destiné á s'engager sur ladite patte verticale.

La presente invention permet de remédier aux inconvénients précités et a pour but la réalisation d'une plate-forme support permettant un positionnement très précis de la grille de connexion.

Un autre but de la présente invention est la mise en oeuvre d'une plate-forme support permettant l'utilisation de fils conducteurs de même longueur minimale quel que soit le brin conducteur considéré.

Un autre but de la présente invention est la mise en oeuvre d'une technique d'assemblage et de montage des pastilles de circuits intégrés permettant par l'uniformisation des opérations de soudure des connexions, une diminution des coûts et une amélioration de la fiabilité de tels circuits.

Selon l'invention, la plate-forme support de grille de connexion pour boîtier de composants électroniques tels que les circuits intégrés est constituée par une plaquette conductrice comportant sur une première face un emplacement destiné à recevoir une pastille de circuits intégrés, comportant au voisinage de cet emplacement un bossage comprenant une gorge qui a un fond plan parallèle à la première face de la plaquette conductrice et situé à une cote déterminée par rapport à cette première face, ce fond ayant dans le sens transverse une dimension supérieure à la largeur d'un brin de la grille de connexion destiné à venir s'y appliquer et à y être fixé après un positionnement précis de ladite grille par rapport au dit emplacement.

D'autres caractéristiques de l'invention apparaîtront dans la description et les dessins ci-après où les mêmes références désignent les mêmes éléments et dans lesquels:

— la figure 1, représente une plate-forme support destinée à recevoir une grille de connexion conformément à l'objet de l'invention;
— les figures 2a et 2b représentent respectivement une vue de la plate-forme support et de la grille de connexion après assemblage conformément à un mode de réalisation de l'invention, et une vue en coupe selon un plan de symétrie longitudinale de la figure 2a;
— la figure 3 représente, en vue éclatée, un boîtier de circuits intégrés comportant une plate-forme conformément à l'objet de l'invention.

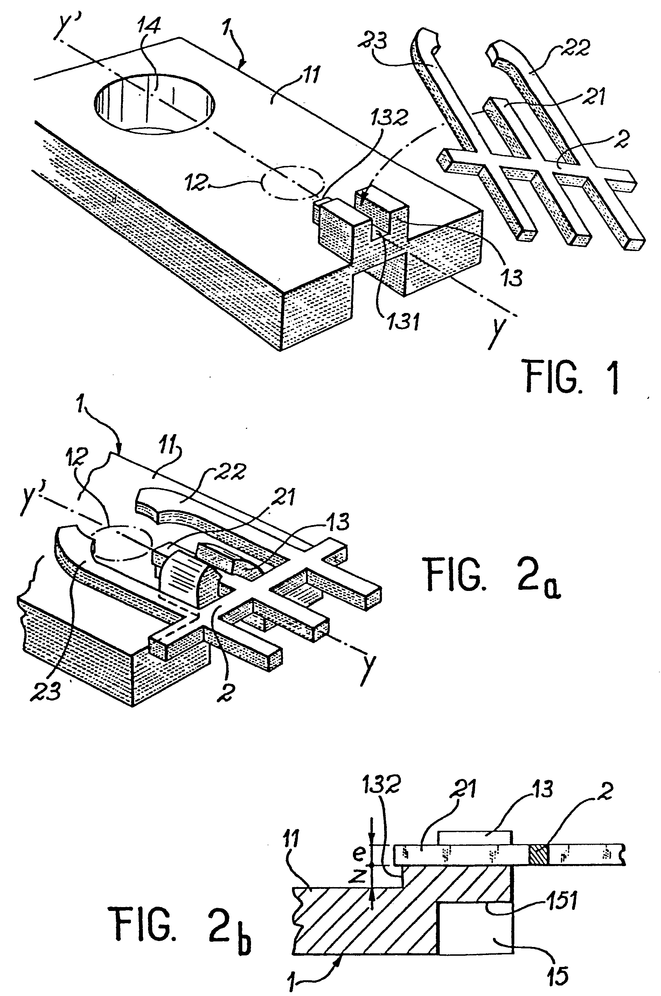

Selon la figure 1, la plate-forme support de grille de connexion pour boîtier de circuits intégrés selon l'invention est consituée par une plaquette conductrice 1. La plaquette comporte sur une première face 11 un emplacement 12 destiné à recevoir une pastille de circuits intégrés. La plaquette comporte également une perforation 14 permettant notamment la fixation de la plate-forme support au châsis d'un appareil. La plaquette est constituée par un métal bon conducteur et a une épaisseur suffisante pour assurer un rôle de dissipateur thermique. Selon l'invention, la plaquette comporte au voisinage de l'emplacement 12, un bossage 13 muni d'une gorge 131. La gorge 131 permet, par l'engagement d'un brin 21 d'une grille de connexion 2 dans cette gorge, l'assemblage de la plate-forme et de la grille de connexion 2. Selon un mode de réalisation non limitatif de la figure 1, la gorge 131 du bossage 13 est symétrique par rapport à un plan de symétrie longitudinale de la plaquette. Sur la figure 1, la plan de symétrie longitudinale de la plaquette est représenté par sa trace Y'Y. La gorge comporte un fond constitué par une surface plane parallèle à la première face 11 de la plaquette conductrice. Ce fond est situé à une cote déterminée par rapport à cette première face 11. Selon la figure 1, le fond de la gorge comporte également une avancée 132 en direction de l'emplacement destiné à recevoir la pastille de circuits intégrés. Cette avancée 132 permet le support mécanique du brin 21 de la grille de connexion entre l'extrémité de ce brin et la zone d'assemblage de la grille de connexion et de la plate-forme. A titre d'exemple le bossage est obtenu par matriçage, la plaquette étant constituée par tout métal susceptible d'être soumis à une telle opération. Selon une caractéristique de l'invention, la gorge 131 a, selon une direction perpendiculaire au plan de symétrie longitudinale de la plaquette, une dimension supérieure à la dimension correspondante du brin de la grille de connexion. Ainsi la gorge permet, avant fixation du brin de la grille de connexion dans la gorge, un positionnement précis selon un plan parallèle au plan de la première face de la plaquette, de l'ensemble de la grille par rapport à l'emplacement 12 destiné à recevoir la pastille de circuits intégrés.

Les figures 2a et 2b sont relatives à un mode de réalisation non limitatif de l'invention. Selon ce mode de réalisation, la gorge comporte, selon une direction perpendiculaire à la première face de la plaquette, une dimension supérieure à la dimension correspondante, ou épaisseur, du brin de grille de connexion 21. Cette dimension permet, après positionnement du brin 21, une fixation de la grille de connexion par sertissage. On a ainsi représenté figure 2a la plate-forme support 1 et la grille de connexion 2 assemblées par sertissage, les bords supérieurs de la gorge 131 étant rabattus par sertissage sur le brin 21 de la grille de connexion 2 après engagement de ce brin et positionnement de la grille de connexion 2 par rapport à l'emplacement destiné à recevoir la pastille de circuits intégrés 12. On a représenté figure 2b une vue en coupe selon le plan de symétrie Y'Y de la figure 2a. Selon la figure 2b, le brin 21 fixé par sertissage repose sur le fond de la gorge et son avancée 132. Le fond de la gorge 131 constitué par une surface plane et son avancée 132 comprenant une surface supérieure plane coplanaire au plan de la gorge ont une cote z par rapport à la première face 11 de la plaquette. La détermination précise de cette cote z, compte tenu de l'epaisseur determinée e de chaque brin de grille tel que 21, les brins tels que 22, 23 ayant par construction la même épaisseur que le brin 21, permet de définir avec précision la cote z+e du plan de soudure des brins de connexion de grille avec les fils de connexion permettant de relier ces brins de connexion à la pastille de circuits intégrés. Cette dernière cote identique pour tous les brins de grille permet notamment d'augmenter le rendement de l'opération de soudure des fils, lors d'une opération de soudure automatique. Selon la figure 2b, le bossage étant obtenu par matriçage de la plaquette conductrice, la plaquette comporte en vis-à-vis du bossage 13 dans l'épaisseur de la plaquette une évidure 15 comportant une face 151 parallèle à la première face de la plaquette 11. L'existence dans l'évidure 15 d'une face 151 parallèle à la première face de la plaquette permet, compte tenu de la forme préférentielle parallèlépipédique de cette plaquette, un meilleur positionnement des outils de sertissage pour lesquels une position d'appui sur la première face 11 de la plaquette, sur la face 151 de l'évidure parallèle à cette première face et sur une face parallèle opposée à la première face 11 de la plaquette est ainsi assurée, l'opération de sertissage étant ainsi facilitée. Elle peut être effectuée en raison des facilités de positionnement et d'appui des outils de sertissage avec une très grande précision. Le positionnement précis de la grille de connexion 2 lors de l'opération de fixation par sertissage autorisant également une fixation de précision dans cette position, permet d'obtenir une position des extrémités des brins tels que 21, 22, 23 de la grille de connexion 2 sensiblement identique par rapport au centre de l'emplacement 12 destiné à recevoir la pastille de circuits intégrés. Il est ainsi possible d'assurer la connexion de chacun des brins aux points de contacts de la pastille de circuits intégrés à l'aide de fils de connexion de longueurs sensiblement voisines. De ce fait, les connexions entre la pastille de circuits intégrés et les brins de connexion sont pratiquement identiques et de qualité comparable. Le mode de fixation par sertissage a été donné à titre d'exemple, tout mode de fixation autre, tel que par exdmple fixation par brasure, ne sort pas du cadre de la présente invention. La plate-forme support de grille de connexion pour boîtier de circuits intégrés selon l'invention ne nécessitant aucun pliage, peut être réalisée à partir de plaquette conductrice de forte épaisseur cest-à-dire de plaquette conductrice d'épaisseur supérieure à 1,5 mm. La forme de réalisation selon l'invention est ainsi particulièrement adaptée aux circuits pour lesquels une dissipation thermique importante est nécessaire.

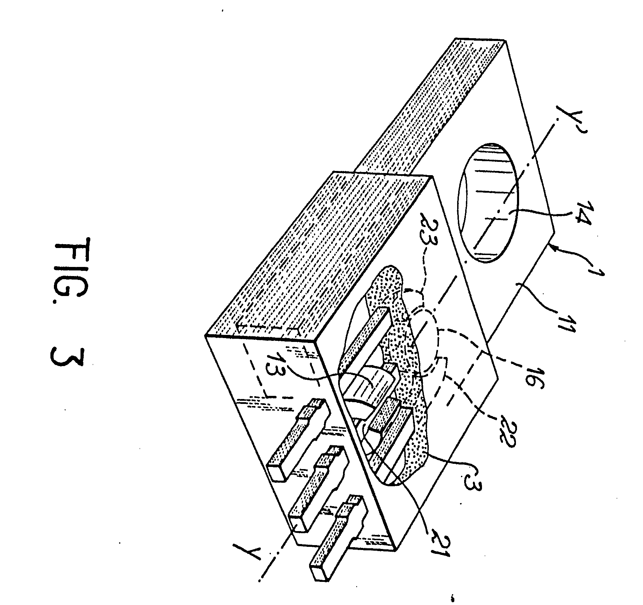

La figure 3 représente un boîtier de circuits intégrés comportant une plate-forme support de grille de connexion selon l'invention. Selon la figure 3, le boîtier comprend, ainsi que représenté en vue éclatée, un brin conducteur 21 assemblé par sertissage de brins conducteurs tels que 22, 23 électriquement isolés de la plate-forme. Les brins conducteurs sont isolés de la plate-forme et rendus solidaires de celle-ci par un enrobage de résine thermodurcissable 3. Sur la figure 3, la pastille de circuits intégrés 16 est représentée disposée à l'emplacement 12 destiné à la recevoir. Les fils conducteurs assurant les connexions entre les brins conducteurs tels que 21, 22, 23 et la pastille de circuits intégrés 16 n'ont pas été représentés afin de ne pas nuire à la clarté de la figure 3. Les brins 21, 22, 23 de la grille de connexion ont été également isolés les uns des autres, la barre transversale reliant chaque brin et constituant la grille de connexion ayant été sectionnée. Selon la figure 3, une grille de connexion comportant seulement trois brins de connexion a été représentée pour ne pas nuire à la clarté de cette figure. Bien entendu tout mode de réalisation dans lequel la grille de connexion, et en définitive le boîtier de circuits intégrés, comporte un nombre supérieur de brins conducteurs, dont l'un est assemblé par exemple par sertissage à une plate-forme selon l'objet de l'invention, ne sort pas du cadre de cette dernière. L'objet de l'invention n'est pas limité à une plate-forme support de grille de connexion pour boîtier de circuits intégrés et peut notamment être utilisé pour la connexion de composants électroniques discrets tels que, par exemple, des transistors.

**Revendications**

1. Plate-forme support de grille de connexion (2) pour boîtier de composants électroniques tels que les circuits intégrés constituée par une plaquette conductrice (1) comportant sur une première face (11) un emplacement (12) destiné à recevoir une pastille de circuits intégrés, comportant au voisinage de l'emplacement un bossage (13) comprenant une gorge (131), caractérisée en ce que cette gorge a un fond plan parallèle à la première face de la plaquette conductrice et situé à une cote déterminée (z) par rapport à cette première face, ce fond ayant dans le sens transverse une dimension supérieure à la largeur d'un brin (21) de la grille de connexion (2) destiné à venir s'y appliquer et à y être fixé après un positionnement précis de ladite grille par rapport à l'emplacement (12).

2. Plate-forme selon la revendication 1, caractérisée en ce que le bossage (13) résulte d'un matriçage de la plaquette conductrice.

3. Plate-forme selon l'une des revendications 1 ou 2, caractérisée en ce que le fond de la gorge, constitué par une surface plane, comporte une avancée (132) en direction de l'emplacement (12) destiné à recevoir la pastille de circuits intégrés.

4. Plate-forme selon l'une quelconque des revendications 1 à 3, caractérisée en ce que la gorge a une profondeur supérieure à l'épaisseur du brin de la grille de connexion, ce qui permet, après positionnement du brin, une fixation de la grille de connexion par sertissage.

5. Boîtier de composant électronique comportant une plateforme support de grille de connexion selon l'une des revendications précédentes, caractérisé en ce qu'il comprend un brin conducteur assemblé par sertissage audit bossage et une pluralité de brins (21, 22, 23) conducteurs électriquement isolés de la plateforme ainsi que les uns des autres et rendus solidaires de celle-ci par un enrobage de résine thermodurcissable (3).

**Patentansprüche**

1. Tragplatte für Anschlußgitter (2) eines Gehäuses für elektronische Bauteile wie integrierte Schaltungen, gebildet aus einer leitfähigen Platte (1), die auf einer ersten Fläche (11) eine Stelle (12) zur Aufnahme eines integrierten Schaltungsplättchens aufweist, mit einer Erhebung (13) in der Nähe dieser Stelle, welche eine Rille (131) aufweist, dadurch gekennzeichnet, daß diese Rille einen ebenen, parallel zu der ersten Fläche der leitenden Platte verlaufenden Boden aufweist, der auf einer vorbestimmten Höhe (z) in Bezug auf diese erste Fläche liegt und in Querrichtung eine Abmessung aufweist, die größer ist als die Breite eines Streifens (21) des Anschlußgitters (2), der dazu bestimmt ist, dagegen angelegt und dort befestigt zu werden, nachdem das Gitter in Bezug auf die Stelle (12) präzise positioniert wurde.

2. Tragplatte nach Anspruch 1, dadurch gekennzeichnet, daß die Erhebung (13) durch Prägung der leitfähigen Platte gebildet ist.

3. Tragplatte nach Anspruch 1 oder 2, dadurch gekennzeichnet, daß der Boden der Rille, der eine ebene Oberfläche bildet, einen Fortsatz (132) in Richtung der Stelle (12) zur Aufnahme des integrierten Halbleiterplättchens aufweist.

4. Tragplatte nach einem der Ansprüche 1 bis 3, dadurch gekennzeichnet, daß die Rille eine Teife aufweist, die größer als die Dicke des Streifens des Anschlußgitters ist, wodurch nach der Positionierung des Streifens eine Befestigung des Anschlußgitters durch Einfassung erfolgen kann.

5. Gehäuse für elektronisches Bauteil mit einer Tragplatte für ein Anschlußgitter nach einem der vorstehenden Ansprüche, dadurch gekennzeichnet, daß es einen leitfähigen Streifen aufweist, der durch Einfassung in der Erhebung befestigt ist, und eine Mehrzahl von Leiterstreifen (21, 22, 23) aufweist, die elektrisch von der Tragplatte und voneinander isoliert sind, sowie mit dieser durch Umhüllung mit wärmehärtbarem Harz (3) fest verbunden sind.

## Claims

1. Connection frame (2) carrier plate for the housing of electronic components such as integrated circuits, formed of a conducting plate (1) having a location (12) on a first face (11) for receiving an integrated circuit chip, comprising a boss (13) in the neighborhood of the location and provided with a groove (131), characterized in that this groove has a plane bottom which is parallel to said first face of the conducting plate and is located at a determined level (z) with respect to said first face, the bottom having a transverse dimension exceeding the width of a strip (21) of the connection grid (2) to be applied thereagainst and affixed thereto after having precisely positioned said grid with respect to said location (12).

2. Carrier plate in accordance with claim 1, characterised in that said boss (13) is formed by embossing the conducting plate.

3. Carrier plate in accordance with claim 1 or 2, characterised in that the bottom of the groove formed by a plane surface comprises an extension (132) in the direction of the location (12) for receiving the integrated circuit chip.

4. Carrier plate in accordance with any of claims 1 to 3, characterized in that the groove has a depth exceeding the thickness of the strip of the connection grid, allowing the connection grid to be secured by setting after positioning of the strip.

5. Electronic component housing comprising a connection grid carrier plate in accordance with any of the preceding claims, characterised in that it comprises a conducting strip secured to the boss by setting and a plurality of conducting strips (21, 22, 23) which are electrically insulated from the carrier plate and from each other and are joined thereto by embedding into thermosetting resin (3).

FIG. 1

FIG. 2a

FIG. 2b

FIG. 3